**Europäisches Patentamt**

**European Patent Office**

**Office européen des brevets**

(19)

(11) Veröffentlichungsnummer: **0 183 962**
**B1**

(12) # EUROPÄISCHE PATENTSCHRIFT

(45) Veröffentlichungstag der Patentschrift:
**29.11.89**

(51) Int. Cl.⁴: **H 01 L 21/203, C 30 B 23/02**

(21) Anmeldenummer: **85113440.3**

(22) Anmeldetag: **23.10.85**

(54) **Verfahren zur Dotierung von Halbleitermaterial.**

(30) Priorität: **22.11.84 DE 3442460**

(43) Veröffentlichungstag der Anmeldung:
**11.06.86 Patentblatt 86/24**

(45) Bekanntmachung des Hinweises auf die Patenterteilung:
**29.11.89 Patentblatt 89/48**

(84) Benannte Vertragsstaaten:
**DE FR GB**

(56) Entgegenhaltungen:
**US-A- 4 213 801**

**PATENTS ABSTRACTS OF JAPAN, Band 7, Nr. 158
(E-186) [1303], 12. Juli 1983; & JP - A - 58 67 020
(KONISHIROKU SHASHIN KOGYO K.K.) 21-04-1983
RADIATION EFFECTS, Band 9, 1971, Selten 1-4, Gordon
and Breach Science Publishers Ltd., Glasgow, GB; T.
ITOH et al.: "Epitaxial growth of silicon assisted by ion
implantation"
PATENTS ABSTRACTS OF JAPAN, Band 7, Nr. 65
(E-165) [1210], 18. März 1983; & JP - A - 57 211 724
(NIPPON DENKI K.K.) 25-12-1982
T.Y.Ota, J.Electrochem.Soc., vol.126(10), p.1761ff(1979)**

(73) Patentinhaber: **Licentia Patent-Verwaltungs-GmbH,
Theodor-Stern-Kai 1, D-6000 Frankfurt/Main 70 (DE)**

(72) Erfinder: **Jorke, Helmut, Böhmenstrasse 76,
D-7929 Gerstetten (DE)**
Erfinder: **Kibbel, Horst, Buchenstrasse 23,
D-7904 Erbach (DE)**

(74) Vertreter: **Schulze, Harald Rudolf, Dipl.-Ing. et al,
Licentia Patent-Verwaltungs-GmbH
Theodor-Stern-Kai 1, D-6000 Frankfurt/Main 70 (DE)**

## Beschreibung

Die Erfindung betrifft ein Verfahren zur Dotierung von Halbleitermaterial nach dem Oberbegriff des Patentanspruchs 1.

Bei der Herstellung von Halbleiterbauelementen, z.B. Transistoren, ist es erforderlich, lediglich eine dünne Schicht eines Halbleitermaterials zu dotieren, z.B. für die Herstellung von pn-Übergängen und/oder von Anschlusskontakten. Eine derartige Dotierung ist möglich mit Hilfe der niederenergetischen Ionenimplantation in eine wachsende MBE-Schicht. Dazu wird das zu dotierende Halbleitermaterial einer Teilchenstrahlung (Korpuskularstrahlung) ausgesetzt, welche den Dotierstoff in einem ionisierten Zustand, z.B. ionisierte Atome und/oder Moleküle, enthält. Diese Ionen erhalten beim Durchlaufen durch ein elektrisches Feld eine hohe kinetische Energie, z.B. ungefähr 500eV, so dass ein Eindringen des ionisierten Dotierstoffs in das damit beschossene Halbleitermaterial möglich wird (Lit. T.Y.Ota, J. Electrochem. Soc., Vol. 126 (10), 1761 (1979)). Ein derartiges Verfahren ist in nachteiliger Weise unwirtschaftlich, denn es sind insbesondere kostenungünstige Geräte erforderlich, um in wiederholbarer Weise ein bestimmtes Dotierprofil zu erzeugen.

Der Erfindung liegt daher die Aufgabe zugrunde, ein gattungsgemässes Verfahren dahingehend zu verbessern, dass die kostengünstige Herstellung von nahezu beliebig vorgebbaren Dotierstoff-Konzentrationsprofilen möglich wird.

Diese Aufgabe wird gelöst durch die im kennzeichnenden Teil des Patentanspruchs 1 angegebenen Merkmale. Zweckmässige Ausgestaltungen sind den Unteransprüchen entnehmbar.

Ein erster Vorteil der Erfindung besteht darin, dass es möglich ist, dotierte Halbleiterschichten herzustellen, deren Schichtdicke im nm-Bereich liegt. Ein zweiter Vorteil besteht darin, dass es möglich ist, insbesondere bei der Molekularstrahlepitaxie-Beschichtung von Siliciumscheiben bei einer niedrigen Epitaxietemperatur eine Antimon (Sb)-dotierte Silicium (Si)-Halbleiterschicht zu erzeugen.

Die Erfindung wird im folgenden anhand eines Ausführungsbeispiels näher erläutert.

In einer Molekularstrahlepitaxie(MBE)-Anlage wird zunächst auf ein Halbleitersubstrat, z.B. eine Siliciumscheibe mit einem Durchmesser von ungefähr 100 mm und einer Dicke von ungefähr 0,5 mm, eine einatomige Adsorptionsschicht aufgebracht, die z.B. aus Antimon besteht. Wird diese Sb-Adsorptionsschicht nun während eines MBE-Vorganges bei einer Temperatur von ungefähr 900 K einem Teilchenstrom aus elektrisch neutralen Si-Atomen und/oder Si-Molekülen ausgesetzt, die z.B. durch Erhitzen eines Si-Körpers entstanden sind, so lagern sich diese Si-Atome und/oder Si-Moleküle auf dem darunterliegenden Si-Halbleitersubstrat an. Es entsteht eine nur geringe Sb-dotierte epitaktische Si-Halbleiterschicht.

Wird dagegen die Sb-Adsorptionsschicht bei einer Temperatur von ungefähr 900 K einer Teilchenstrahlung ausgesetzt, die zusätzlich Si-Ionen enthält mit einer Energie von ungefähr 250 eV, so entsteht in überraschender Weise eine Sb-dotierte Si-Halbleiterschicht. Dabei entsteht eine Sb-Konzentration von ungefähr $10^{19}/cm^3$. Es ist zweckmässig, den Dotierstoffeinbau in der Halbleiterschicht zu unterstützen durch ein nachträglich angewandtes Erhitzen der Halbleiterschicht auf eine Temperatur, die ein Ausheilen von Kristallbaufehlern ermöglicht. Diese beträgt bei Silicium z.B. ungefähr 1000 K. Durch beispielsweise Wahl der Zeit, in welcher die ionisierte Teilchenstrahlung angewandt wird, ist ein nahezu beliebig vorgebbares Dotierstoff-Konzentrationsprofil in der Halbleiterschicht einstellbar.

Während des epitaktischen Aufwachsens der Halbleiterschicht wird die Konzentration des Dotierstoffs in der Adsorptionsschicht gesteuert und/oder geregelt durch Wahl der Temperatur der Halbleiterschicht derart, dass die vorhandene Desorption des Dotierstoffs vernachlässigbar ist und/oder durch Nachlieferung des Dotierstoffs z.B. durch Aufdampfen mit Hilfe einer entsprechenden Aufdampfquelle.

## Patentansprüche

1. Verfahren zur Dotierung von Halbleitermaterial, bei welchem unter Anwendung einer Teilchenstrahlung auf einem Halbleitersubstrat eine dotierte Halbleiterschicht erzeugt wird, dadurch gekennzeichnet,
– dass auf dem Halbleitersubstrat zunächst eine einatomige Adsorptionsschicht aufgebracht wird, welche aus dem Dotierstoff besteht und
– dass dann durch Anwendung der Teilchenstrahlung, bestehend aus neutralen Atomen und Molekülen oder bestehend aus neutralen Atomen und Molekülen, sowie beschleunigten Ionen auf dem Halbleitersubstrat eine Halbleiterschicht epitaktisch aufgewachsen wird.

2. Verfahren zur Dotierung von Halbleitermaterial nach Anspruch 1, dadurch gekennzeichnet, dass als beschleunigte Ionen ionisierte Wirtsgitteratome des Halbleitersubstrats verwendet werden.

3. Verfahren zur Dotierung von Halbleitermaterial nach Anspruch 1 oder Anspruch 2, dadurch gekennzeichnet, dass beschleunigte Ionen mit einer Energie im Bereich von 10 eV bis 10000 eV verwendet werden, vorzugsweise im Bereich von 100 eV bis 1000 eV.

4. Verfahren zur Dotierung von Halbleitermaterial nach einem der vorhergehenden Ansprüche, dadurch gekennzeichnet, dass als Halbleitersubstrat Silicium verwendet wird und dass die Adsorptionsschicht aus Antimon und/oder Gallium besteht.

5. Verfahren zur Dotierung von Halbleitermaterial nach einem der vorhergehenden Ansprüche, dadurch gekennzeichnet, dass das Konzentrationsprofil des Dotierstoffs in der Halbleiterschicht gesteuert wird durch Steuerung der Temperaturen der Oberfläche der Halbleiterschicht und/oder durch Nachlieferung des Dotierstoffs in die Adsorptionsschicht.

## Claims

1. Method for the doping of semiconductor material, in which method a doped semiconductor layer is produced on a semiconductor substrate with the application of a particle radiation, characterised thereby, that a mono-atomic adsorption layer, which consists of the doping substance, is initially applied on the semiconductor substrate and a semiconductor layer is then grown epitaxially on the smiconductor substrate through application of the particle radiation consisting of neutral atoms and molecules or consisting of neutral atoms and molecules as well as accelerated ions.

2. Method for the doping of semiconductor material according to claim 1, characterised thereby, that ionised host lattice atoms of the semiconductor substrate are used as accelerated ions.

3. Method for the doping of semiconductor material according to claim 1 or claim 2, characterised thereby, that accelerated ions with an energy in the range of 10 eV to 10000 eV, preferably in the range of 100 eV to 1000 eV, are used.

4. Method for the doping of semiconductor material according to one of the preceding claims, characterised thereby, that silicon is used as semiconductor substrate and that the adsorption layer consists of antimony or gallium.

5. Method for the doping of semiconductor material, according to preceding claims, characterised thereby, that the concentration profile of the doping substance in the semiconductor layer is controlled by control of the temperatures of the surface of the semiconductor layer and/or by replenishment of the doping substance into the adsorption layer.

## Revendications

1. Procédé pour le dopage d'un matériau semi-conducteur dans lequel on produit une couche semi-conductrice dopée sur un substrat semi-conducteur par application d'un faisceau de particules, caractérisé en ce que
– on applique d'abord sur le substrat semi-conducteur une couche d'adsorption monoatomique, qui consiste en l'agent dopant, et
– on fait ensuite pousser par épitaxie sur le substrat semi-conducteur une couche semi-conductrice par application du faisceau de particules consistant en atomes et molécules neutres ou consistant en atomes et molécules neutres, ainsi qu'en ions accélérés.

2. Procédé pour le dopage d'un matériau semi-conducteur selon la revendication 1, caractérisé en ce que l'on utilise comme ions accélérés des atomes ionisés du réseau hôte du substrat semi-conducteur.

3. Procédé pour le dopage d'un matériau semi-conducteur selon la revendication 1 ou 2, caractérisé en ce que l'on utilise des ions accélérés ayant une énergie dans l'intervalle de 10 eV à 10000 eV, de préférence de 100 eV à 1000 eV.

4. Procédé pour le dopage d'un matériau semi-conducteur selon l'une des revendications précédentes, caractérisé en ce que l'on utilise comme substrat semi-conducteur le silicium et en ce que la couche d'adsorption consiste en antimoine et/ou en gallium.

5. Procédé pour le dopage d'un matériau semi-conducteur selon l'une des revendications précédentes, caractérisé en ce que le profil de concentration de l'agent dopant dans la couche semi-conductrice est commandé par réglage de la température de la surface de la couche semi-conductrice et/ou par approvisionnement de l'agent dopant dans la couche d'adsorption.